Europäisches Patentamt

European Patent Office

Office européen des brevets

(19)

(11) Numéro de publication : **0 021 869**
**B1**

(12) **FASCICULE DE BREVET EUROPÉEN**

(45) Date de publication du fascicule du brevet :
01.06.83

(51) Int. Cl.³ : **H 01 L 29/91**, H 01 L 29/06

(21) Numéro de dépôt : 80400625.2

(22) Date de dépôt : 08.05.80

(54) **Procédé pour réaliser une diode Schottky à tenue en tension améliorée.**

(30) Priorité : 22.06.79 FR 7916056

(43) Date de publication de la demande :
07.01.81 Bulletin 81/01

(45) Mention de la délivrance du brevet :
01.06.83 Bulletin 83/22

(84) Etats contractants désignés :
DE GB

(56) Documents cités :
DE A 2 425 209
**SOLID STATE ELECTRONICS, vol. 20, no. 6, juin 1977 Oxford GB A. RUSU : « The metaloverlap laterally-diffused (mold) Schottky diode », pages 499-506**

(73) Titulaire : **THOMSON-CSF**
**173, Boulevard Haussmann**
**F-75379 Paris Cedex 08 (FR)**

(72) Inventeur : **Roche, Marcel**
**"THOMSON-CSF" - SCPI 173, Bld Haussmann**
**F-75360 Paris Cedex 08 (FR)**
Inventeur : **Litot, Jean-Paul**
**"THOMSON-CSF" - SCPI 173, Bld Haussmann**
**F-75360 Paris Cedex 08 (FR)**

(74) Mandataire : **de Beaumont, Michel et al**
**THOMSON-CSF SCPI 173, Bld Haussmann**
**F-75379 Paris Cedex 08 (FR)**

Jouve, 18, rue St-Denis, 75001 Paris, France

## Procédé pour réaliser une diode Schottky à tenue en tension améliorée

La présente invention concerne un procédé pour réaliser une diode Schottky du type spécifié dans le préambule de la revendication 1.

Dans le domaine des composants à semiconducteurs il est connu d'utiliser, notamment dans des circuits de détection ou de mélange à haute fréquence, des diodes Schottky constituées par un contact métal-semiconducteur faiblement dopé, qui présente des propriétés de redressement. Cependant un inconvénient de telles diodes réside dans le fait que dans de nombreuses applications, leur tenue en tension est un facteur de limitation important.

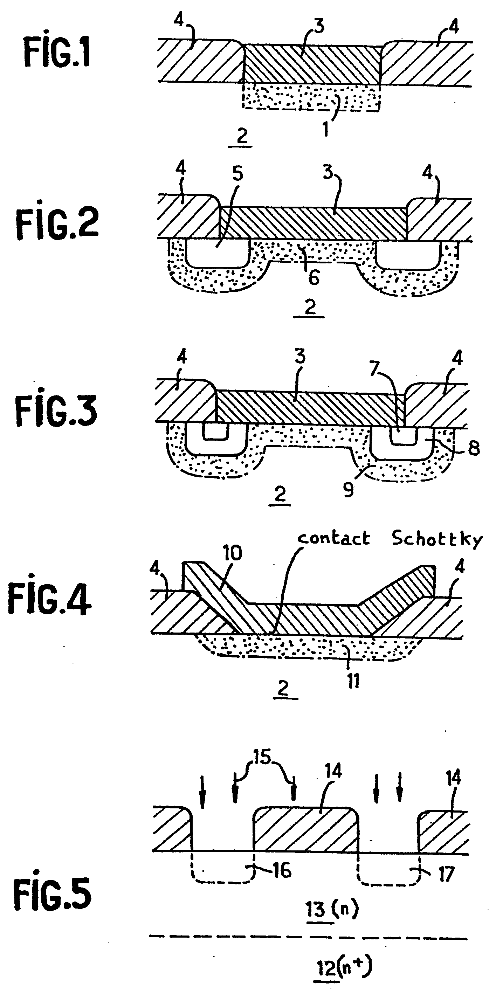

Sur la figure 1, annexée à la présente demande, on a représenté une vue en coupe schématique d'une diode Schottky réalisée au niveau d'une couche 2 de silicium monocristallin du type n et surmontée d'une couche métallique 3. La référence 4 désigne la couche d'oxyde de silicium $SiO_2$. Or la région 1, qui constitue la zone de charge d'espace, possède, au niveau du pourtour de la diode, un rayon de courbure faible et il en résulte un champ électrique élevé qui provoque fréquemment un claquage prématuré de la diode. Ce dernier ainsi que le courant dans la diode sont également très sensibles aux effets de surface.

Dans l'art antérieur, une première solution, illustré sur la figure 2 annexée à la présente demande, a consisté à utiliser un anneau de garde 5 réalisé par diffusion, de type p, dans le cas d'un silicium de type n. Sur la figure 2, on a conservé les mêmes références que celles de la figure 1 pour désigner des éléments de même nature. Dans ce cas, le résultat obtenu est une extension de la zone de charge d'espace 6, avec une forme plus arrondie sur les bords de la diode Schottky, ce qui entraîne une amélioration de la tenue en tension, mais à partir d'un certain niveau un courant finit par passer dans la diode à jonction, parasite, que constitue l'anneau de garde et qui peut stocker des porteurs de charge dans certaines conditions de polarisation, et il en résulte un temps de commutation élevé.

Il a alors été proposé (figure 3), pour éviter tout stockage de porteurs minoritaires et supprimer le passage du courant parasite, de mettre en place deux anneaux de garde 7, 8 l'un de type $n^+$, l'autre de type $p^+$, réalisant deux jonctions disposées tête-bêche. Cette disposition augmente assurément l'étendue de la zone de charge d'espace, qui prend la forme 9, mais, outre le fait que cette solution est assez complexe, ceci se traduit par un accroissement de la surface de l'élément, ce qui est nuisible pour l'obtention d'une densité élevée d'intégration des circuits.

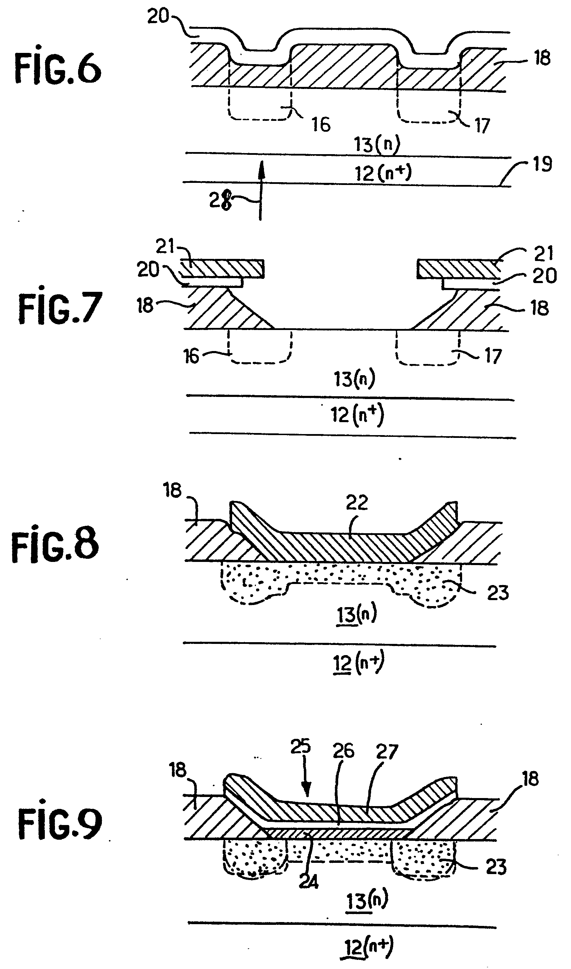

Enfin une autre solution a été proposée selon laquelle une amélioration de la tenue en tension est obtenue à l'aide d'un anneau de garde métallique 10 (figure 4) déposé sur le pourtour en biseau de l'oxyde $SiO_2$ 4. En donnant à cet anneau 10 une forme particulière, telle que représentée, le champ électrique se trouve réduit au niveau des bords de la diode, ce qui améliore la tenue en tension. La zone de charge d'espace est désignée dans ce cas par la référence 11. Néanmoins il s'avère que les résultats dépendent du profil de l'anneau de garde et que la limitation provient de la périphérie.

Dans les trois solutions connues visant à améliorer la tenue en tension de diodes Schottky, cette tenue en tension reste cependant de qualité médiocre ; la caractéristique de la diode est loin d'être idéale et on lui adjoint, en outre, dans les deux premières solutions connues, des éléments parasites, du type capacités, diode de stockage, etc.

Pour résoudre ce problème l'invention utilise le fait connu, selon lequel la zone de charge d'espace est d'autant plus étendue que le dopage est plus faible, et met en œuvre de façon particulière ce principe en réalisant un appauvrissement (« déplétion ») de la zone de charge d'espace au niveau de la périphérie de la diode, et ce notamment dans le cas d'une diode Schottky comportant un anneau de garde métallique, ce qui accroît plus encore les performances d'une telle diode, et ce sans l'adjonction d'éléments parasites tels qu'indiqués plus haut.

Ce problème est résolu conformément à l'invention grâce au fait qu'il consiste à appauvrir la zone de charge d'espace sur le pourtour de la diode en modifiant localement le dopage de la couche épitaxiale. Selon l'invention cette modification locale du dopage de la couche épitaxiale est réalisée jusqu'à compensation du dopage de cette couche, et ce au moyen d'une implantation d'ions de bore.

Un article de Rusu et al. paru dans « Solid-State Electronics », 1977, volume 20, pages 499 à 506, décrit une structure analogue à celle de la présente invention, mais le procédé de fabrication est distinct car au lieu de partir d'une couche épitaxiale relativement dopée et de compenser une zone périphérique à celle de la diode, on part d'une structure épitaxiale très faiblement dopée et l'on enrichit la zone de la diode. Ce procédé est beaucoup plus difficile à mettre en œuvre étant donné les difficultés de réalisation d'une couche épitaxiale très faiblement dopée et conduit à une augmentation de la résistance en direct de la diode du fait de l'existence de la couche épitaxiale très peu dopée.

D'autres caractéristiques de mise en œuvre du procédé selon l'invention ressortiront de la description donnée ci-après.

A titre d'exemple on a décrit ci-dessous et illustré schématiquement aux dessins annexés un mode d'exécution du procédé conforme à l'invention.

Les figures 1 à 4, dont il a déjà été fait mention, illustrent l'art antérieur dans le domaine des diodes Schottky.

Les figures 5 à 9 illustrent les différentes phases de mise en œuvre du procédé conforme à l'invention, dans le cas d'une diode Schottky du type à anneau de garde métallique.

Pour la mise en œuvre du procédé on part d'un substrat de silicium fortement dopé, du type n⁺, 12, sur lequel on dépose une couche épitaxiale de type n 13, puis une couche d'oxyde SiO₂ 14. Après masquage, on effectue conformément à l'invention, une implantation d'ions de bore (flèches 15) assurant une compensation locale du dopage de la couche épitaxiale dans les zones 16 et 17, mais sans atteindre le changement de type (figure 5). Ensuite on dépose une nouvelle couche 18 de SiO₂ et, en outre, on désoxyde la face arrière 19 de la structure (figure 6), de sorte que lors de la formation ultérieure d'une couche 20 de SiO₂ dopée au phosphore (SiO₂-P₂O₅), il se produira une diffusion du phosphore (flèche 28), créant ainsi un réseau de piégeage pour les impuretés métalliques. On dépose alors ladite couche 20, puis on dépose une résine photosensible 21 bien connue sous le nom de « photoresist », qu'on éclaire, moyennant l'interposition d'un masque approprié. On dissout ensuite les zones éclairées, et on réalise finalement une structure à profil étagé en biseau de l'oxyde 18, selon une technique classique basée sur une différence des vitesses d'attaque chimique dans l'oxyde 18 et dans la couche d'oxyde dopé 20 (figure 7). Cette forme en biseau de la couche d'oxyde au-dessus des zones 16 et 17 est nécessaire pour obtenir une variation progressive du champ électrique en surface et un appauvrissement (« déplétion ») progressif des charges d'espace dans la couche épitaxiale.

Conformément à l'invention on règle alors le dopage au niveau du contact Schottky au moyen d'une implantation permettant de définir parfaitement ce qu'on appelle la hauteur de barrière Schottky et qui est un paramètre intervenant dans la formule donnant le courant traversant la diode. Ensuite on dépose sur la structure obtenue et on grave un métal approprié 22, comme représenté sur la figure 8, constituant à la fois le métal du contact Schottky et un anneau de garde, la zone de charge d'espace obtenue 23 ayant la forme représentée. On voit nettement que cette zone est plus étendue que dans le cas des dispositifs de l'art antérieur et présente deux parties renflées dans les zones 16 et 17 au niveau de la périphérie du contact Schottky.

Par ailleurs on peut, après avoir déposé le métal, le faire réagir avec le silicium au moyen d'un traitement thermique pour obtenir un siliciure métallique et on élimine ensuite le métal en excès. On dépose ensuite (figure 9), sur le siliciure 24, un sandwich 25 comprenant un métal réfractaire 26 agissant en tant que barrière de diffusion métallique et un métal d'interconnexion 27. Après gravure on aboutit au dispositif représenté sur la figure.

Conformément à l'objet de l'invention, la compensation locale du dopage initial de la couche épitaxiale assure une extension de la zone de charge d'espace dans les zones compensées, beaucoup plus importante que ne le permet un anneau de garde métallique seul et l'on obtient par conséquent une augmentation de la tenue en tension de la diode sans addition d'éléments parasites tels que capacités ou stockage de porteurs.

**Revendications**

1. Procédé pour accroître la tenue en tension d'une diode Schottky, du type comportant :
une couche épitaxiale dopée selon un premier type de conductivité et couverte d'une couche d'oxyde,
une couche métallique établissant le contact Schottky sur une partie superficielle de la couche épitaxiale, au travers d'une fenêtre de la couche d'oxyde, et
un anneau de garde métallique, ce dernier étant situé sur le pourtour de la diode, au-dessus d'une partie de la couche épitaxiale dont le niveau de dopage est inférieur à celui d'une partie de cette même couche épitaxiale en contact avec ladite couche métallique, caractérisé par le fait qu'il consiste à appauvrir localement le niveau de dopage de la couche épitaxiale, par compensation, selon un anneau, sur le pourtour de la diode, tout en maintenant le même type de conductivité.

2. Procédé suivant la revendication 1, caractérisé par le fait qu'on modifie localement le dopage de la couche épitaxiale jusqu'à compensation du dopage initial de cette couche.

3. Procédé suivant les revendications 1 et 2 prises dans leur ensemble, caractérisé par le fait qu'après masquage de la couche épitaxiale de type n, déposée sur un substrat de type n⁺, on réalise la modification locale du dopage initial de la couche épitaxiale au moyen d'une implantation d'ions de bore.

4. Procédé suivant les revendications 1 à 3 prises dans leur ensemble, caractérisé par le fait qu'on compense tout d'abord localement le dopage initial de la couche épitaxiale de type n, qu'on dépose alors sur l'ensemble une couche d'oxyde (SiO₂), dont la partie supérieure est dopée, et dans laquelle on réalise de façon connue une ouverture dont le bord possède un profil en biseau, qu'on règle alors le dopage au niveau du contact Schottky par implantation d'ions pour définir parfaitement la hauteur de barrière Schottky, et qu'on dépose ensuite un métal approprié sur l'ensemble de la structure au niveau du contact.

5. Procédé suivant la revendication 4, caractérisé par le fait que lors du dépôt du métal au niveau du contact Schottky, on dépose simultanément un anneau de garde métallique recouvrant le pourtour du contact et d'un seul tenant avec le métal du contact.

6. Procédé selon l'une des revendications 4 ou 5, caractérisé par le fait que, avant la réalisation du dopage superficiel de la couche d'oxyde, on désoxyde la face arrière de la structure de sorte que, lors du dopage superficiel ultérieur, notamment au phosphore, il se produit une diffusion du phosphore constituant un réseau de piégeage d'impuretés métalliques.

Claims

1. A method for increasing the electric strength of a Schottky diode of the type which comprises an epitaxial layer which is doped in accordance with a first conductivity type and is covered by an oxide layer, a metallic layer which provides for the Schottky contact in a surface portion of the epitaxial layer through a window in the oxide layer, and a metallic guard ring disposed over the periphery of the diode above a part of the epitaxial layer the doping level of which is lower than that of a part of the same epitaxial layer in contact with the metallic layer, characterized in that said method resides in locally depleting the doping level of the epitaxial layer by compensation in accordance with a ring over the periphery of the diode, while maintaining the same conductivity type.

2. A method as claimed in claim 1, characterized in that the doping of the epitaxial layer is locally modified until the initial doping of this layer is compensated.

3. A method as claimed in claims 1 and 2 in combination, characterized in that after masking of the n-type epitaxial layer, which is deposited on an $n^+$-type substrate, the local modification of the initial doping of the epitaxial layer is performed by means of an implantation of boron ions.

4. A method as claimed in claims 1 to 3 in combination, characterized in that first the initial doping of the n-type epitaxial layer is locally compensated, that thereupon an oxide layer ($SiO_2$) is deposited on the entire structure, the top part of said oxide layer being doped and an opening being formed therein in a known manner, the edge of said opening having a bevelled profile, that thereupon the doping at the level of the Schottky contact is controlled by ion implantation so as to completely define the height of the Schottky barrier, and that thereupon a suitable metal is deposited on the entire structure at the level of the contact.

5. A method as claimed in claim 4, characterized in that, while the metal is deposited at the level of the Schottky contact, a metallic guard ring is simultaneously deposited which covers the periphery of the contact and is integral with the metal thereof.

6. A method as claimed in any of the claims 4 and 5, characterized in that prior to the making of the surface doping of the oxide layer the rear side of the structure is deoxidized so that during the later surface doping, especially with phosphorus, a diffusion of the phosphorus will occur which forms a network for the trapping of metallic impurities.

Ansprüche

1. Verfahren zum Vergrößern der Spannungsfestigkeit einer Schottky-Diode des Typs, der eine epitaktische Schicht, die gemäß einem ersten Leitfähigkeitstyp dotiert und mit einer Oxidschicht bedeckt ist, eine metallische Schicht, welche den Schottky-Kontakt in einem Oberflächenbereich der epitaktischen Schicht durch ein Fenster der Oxidschicht herstellt, und einem metallischen Schutzring, der über den Umfang der Diode oberhalb eines Teils der epitaktischen Schicht angeordnet ist, deren Dotierungsniveau geringer als das eines Teils der gleichen epitaktischen Schicht, ist, die in Kontakt mit der metallischen Schicht ist, aufweist, dadurch gekennzeichnet, daß es darin besteht, das Dotierungsniveau der epitaktischen Schicht durch Kompensation gemäß einem Ring über den Umfang der Diode örtlich zu verarmen, wobei jedoch der gleiche Leitfähigkeitstyp aufrechterhalten wird.

2. Verfahren nach Anspruch 1, dadurch gekennzeichnet, daß man örtlich die Dotierung der epitaktischen Schicht bis zur Kompensation der ursprünglichen Dotierung dieser Schicht modifiziert.

3. Verfahren nach den Ansprüchen 1 und 2 zusammengenommen, dadurch gekennzeichnet, daß man nach Maskierung der epitaktischen Schicht vom Typ n, die auf einem Substrat vom Typ $n^+$ abgeschieden ist, die örtliche Modifizierung der ursprünglichen Dotierung der epitaktischen Schicht mittels einer Implantation von Borionen vornimmt.

4. Verfahren nach den Ansprüchen 1 bis 3 zusammengenommen, dadurch gekennzeichnet, daß man zunächst örtlich die ursprüngliche Dotierung der epitaktischen Schicht vom Typ n kompensiert, daß man dann auf der Gesamtheit eine Oxidschicht ($SiO_2$) abscheidet, deren oberer Teil dotiert ist und in der man in bekannter Weise eine Öffnung herstellt, deren Rand ein abgeschrägtes Profil aufweist, daß man dann die Dotierung auf dem Niveau des Schottky-Kontakts durch Ionenimplantation regelt, um die Höhe der Schottky-Barriere vollkommen zu definieren, und daß man anschließend ein geeignetes Metall auf der Gesamtheit der Struktur auf dem Niveau des Kontakts abscheidet.

5. Verfahren nach Anspruch 4, dadurch gekennzeichnet, daß man bei der Abscheidung des Metalls auf dem Niveau des Schottky-Kontakts gleichzeitig einen metallischen Schutzring abscheidet, der den Umfang des Kontakts bedeckt und einstückig mit dem Metall des Kontakts ist.

6. Verfahren nach einem der Ansprüche 4 und 5, dadurch gekennzeichnet, daß man vor der Herstellung der Oberflächendotierung der Oxidschicht die Rückseite der Struktur desoxydiert, so daß bei der späteren Oberflächendotierung insbesondere mit Phosphor eine Diffusion des Phosphors eintritt, welche ein Netz zum Einfangen von metallischen Verunreinigungen bildet.

FIG.1

FIG.2

FIG.3

contact Schottky

FIG.4

FIG.5

_13_ (n)

_12_(n⁺)

FIG.6

FIG.7

FIG.8

FIG.9